(19) Europäisches Patentamt
European Patent Office
Office européen des brevets

(11) **EP 1 828 828 B1**

(12) **EUROPÄISCHE PATENTSCHRIFT**

(45) Veröffentlichungstag und Bekanntmachung des Hinweises auf die Patenterteilung:
**02.03.2011 Patentblatt 2011/09**

(51) Int Cl.:
*G02B 6/42* (2006.01)    *G02B 3/00* (2006.01)

(21) Anmeldenummer: **05849666.2**

(22) Anmeldetag: **12.12.2005**

(86) Internationale Anmeldenummer:
**PCT/DE2005/002235**

(87) Internationale Veröffentlichungsnummer:
**WO 2006/066543 (29.06.2006 Gazette 2006/26)**

(54) **LASERANORDNUNG UND VERFAHREN ZUR HERSTELLUNG EINER LASERANORDNUNG**

LASER ARRANGEMENT AND METHOD FOR PRODUCING A LASER ARRANGEMENT

ENSEMBLE LASER ET PROCEDE DE FABRICATION DUDIT ENSEMBLE LASER

(84) Benannte Vertragsstaaten:
**DE**

(30) Priorität: **21.12.2004 DE 102004061576**
**10.02.2005 DE 102005006052**

(43) Veröffentlichungstag der Anmeldung:
**05.09.2007 Patentblatt 2007/36**

(73) Patentinhaber: **OSRAM Opto Semiconductors GmbH**
**93055 Regensburg (DE)**

(72) Erfinder:
• **STEEGMÜLLER, Ulrich**
**93055 Regensburg (DE)**
• **SINGER, Frank**
**93128 Regenstauf (DE)**
• **WEISS, Guido**
**93059 Regensburg (DE)**

(74) Vertreter: **Epping - Hermann - Fischer Patentanwaltsgesellschaft mbH**
**Ridlerstrasse 55**
**80339 München (DE)**

(56) Entgegenhaltungen:
EP-A- 1 460 456     DE-A- 19 527 026
DE-A1- 10 142 010   US-A- 4 830 454
US-A- 5 705 025     US-A- 5 757 830
US-A- 5 963 577     US-A1- 2001 026 658

• STRZELECKA E M ET AL: "Fabrication of refractive microlenses in semiconductors by mask shape transfer in reactive ion etching" MICROELECTRONIC ENGINEERING, ELSEVIER PUBLISHERS BV., AMSTERDAM, NL, Bd. 35, Nr. 1, Februar 1997 (1997-02), Seiten 385-388, XP004054083 ISSN: 0167-9317
• MCINTYRE K J ET AL: "HIGH-NA, ANAMORPHIC OR ASPHERIC MICROLENSES FOR TELECOMMUNICATIONS AND DATA STORAGE" TRENDS IN OPTICS AND PHOTONICS. DIFFRACTIVE OPTICS AND MICRO-OPTICS. TECHNICAL DIGEST. POSTCONFERENCE EDITION, Bd. 41, 18. Juni 2000 (2000-06-18), Seiten 278-280, XP001120385
• NEMOTO S: "TRANSFORMATION OF WAIST PARAMETERS OF A GAUSSIAN BEAM BY A THICK LENS" APPLIED OPTICS, OSA, OPTICAL SOCIETY OF AMERICA, WASHINGTON, DC, US, Bd. 29, Nr. 6, 20. Februar 1990 (1990-02-20), Seiten 809-816, XP000101334 ISSN: 0003-6935
• LIAU Z L ET AL: "SIMPLE COMPACT DIODE-LASER/MICROLENS PACKAGING" IEEE JOURNAL OF QUANTUM ELECTRONICS, IEEE SERVICE CENTER, PISCATAWAY, NJ, US, Bd. 33, Nr. 3, März 1997 (1997-03), Seiten 457-461, XP000680490 ISSN: 0018-9197
• LIAU Z L ET AL: "ACCURATE FABRICATION OF ANAMORPHIC MICROLENSES AND EFFICIENT COLLIMATION OF TAPERED UNSTABLE-RESONATOR DIODE LASERS" APPLIED PHYSICS LETTERS, AIP, AMERICAN INSTITUTE OF PHYSICS, MELVILLE, NY, US, Bd. 64, Nr. 25, 20. Juni 1994 (1994-06-20), Seiten 3368-3370, XP000454590 ISSN: 0003-6951

## Beschreibung

Die vorliegende Erfindung betrifft eine Laseranordnung sowie ein Verfahren zur Herstellung einer Laseranordnung.

Die Druckschrift US 4,830,454 beschreibt eine optische Linse.

Die Druckschrift Strzelecka E. M. et al.: "Fabrication of refractive microlenses in semiconductors by mask shape transfer in reactive ion etching", Microelectronic Engineering, Elsevier Publishers BV., Amsterdam, NL, Bd. 35, Nr. 1, Februar 1997, Seiten 385-388 beschreibt die Herstellung einer brechenden Mikrolinse aus einem Halbleitermaterial.

Die Druckschrift DE 10142010 A1 beschreibt ein Verfahren zur Herstellung einer Linse aus GaP-basiertem Halbleitermaterial.

Die Druckschrift DE 19527026 A1 beschreibt einen optoelektronischen Wandler und dessen Herstellungsverfahren.

Die Druckschrift US 5,963,577 beschreibt eine Laseranordnung mit einer zylindrischen Mikrolinse.

Die Druckschriften Liau Z. L. et al.: "Simple Compact Diode-Laser/Microlens Packaging", IEEE Journal of Quantum Electronics, IEEE Service Center, Piscataway, NJ, US, Bd. 33, Nr. 3, März 1997, Seiten 457-461 und US 5,757,830 beschreiben jeweils eine Laseranordnung gemäß dem Oberbegriff des Patentanspruchs 1.

Es ist Aufgabe der vorliegenden Erfindung, eine , Laservorrichtung sowie ein Verfahren zur Herstellung einer Laservorrichtung anzugeben.

Die Erfindung betrifft eine Laseranordnung aufweisend

- einen zur Erzeugung von elektromagnetischer Strahlung geeigneten Halbleiterchip, und
- eine asphärische plankonvexe Linse, die ein Material mit einem Brechungsindex von wenigstens 3,0 enthält, bei der die Höhe des konvex gekrümmten Bereichs maximal ein Fünftel der Dicke der Linse beträgt, wobei
- die Dicke der Linse der Abstand zwischen einem Scheitelpunkt des konvex gewölbten Bereichs und der dem konvex gewölbten Bereich gegenüberliegenden planen Strahlungseintrittsfläche ist,
- die Linse dem Halbleiterchip in Abstrahlrichtung nachgeordnet ist,
- die Linse mit ihrer planen Strahlungseintrittsfläche dem Halbleiterchip zugewandt ist,
- Halbeiterchip und Linse auf einem gemeinsamen Träger (8) aufgebracht sind,
- die Linse zwei einander gegenüberliegende plane Flächen aufweist, die parallel zur optischen Achse der Linse verlaufen und senkrecht auf der planen Strahlungseintrittsfläche stehen,
- die Länge der beiden planen Flächen in Richtung der optischen Achse wenigstens 350 $\mu$m beträgt,

dadurch gekennzeichnet, dass

- die Strahlungsauskoppelfläche des Halbleiterchips in einem Abstand zur Strahlungseintrittsfläche der Linse angeordnet ist, der maximal 80 $\mu$m beträgt,
- die Höhe des konvex gekrümmten Bereichs zwischen 35 $\mu$m und 60 $\mu$m beträgt,
- der gemeinsame Träger ein Leiterrahmen ist,
- die Linse auf dem Leiterrahmen mittels eines Klebstoffs befestigt ist, wobei der Klebstoff zwischen dem Leiterrahmen und der dem Leiterrahmen zugewandten planen Fläche der Linse angeordnet ist, und
- der Halbleiterchip mittels einer Hartlotverbindung auf dem Leiterrahmen befestigt ist.

Die Linse der Laseranordnung ist eine plankonvexe Linse, d. h. die Linse weist wenigstens eine Fläche auf, die im Wesentlichen eben ist. Im Wesentlichen eben bedeutet dabei, dass die Oberfläche der Linse bis auf unvermeidliche, herstellungsbedingte Unebenheiten plan ist, insbesondere dass die Fläche keinen konvex oder konkav gewölbten Bereich aufweist. Bevorzugt bildet die plane Fläche der Linse eine Strahlungseintrittsfläche der Linse.

Weiter weist die plankonvexe Linse wenigstens eine Außenfläche auf, die einen konvex gewölbten Bereich umfasst. Dabei ist es möglich, dass der gewölbte Bereich die gesamte Fläche einnimmt. Das heißt die gesamte Fläche ist dann konvex gewölbt. Weiter ist es möglich, dass der gewölbte Bereich nur einen Teil der Fläche umfasst und der verbleibende Teil der Fläche zum Beispiel eben ausgebildet ist.

Der konvex gewölbte Bereich der Linse ist asphärisch gewölbt. Der gewölbte Bereich ist auf der der Strahlungseintrittsfläche gegenüberliegenden Seite der Linse angeordnet und bildet eine Strahlungsaustrittsfläche der Linse. Das heißt, bevorzugt tritt elektromagnetische Strahlung an der planen Fläche in die Linse ein. Die Strahlung durchquert die Linse auf im Wesentlichen geraden Weg, das heißt ohne im Inneren der Linse nennenswert gestreut oder gebrochen zu werden. Die Strahlung tritt an der Fläche, die den konvex gewölbten Bereich umfasst, aus der Linse wieder aus.

Die Linse ist eine asphärische Linse. Das bedeutet, die Linse weist wenigstens einen asphärisch gewölbten Bereich auf, d. h. eine Fläche, die nicht kugelförmig gewölbt ist. Die Krümmung des asphärisch gewölbten Bereichs kann dabei den Anforderungen an die Linse angepasst sein. Auf diese Weise können beispielsweise Größen wie die numerische Apertur oder die Kollimation der Linse eingestellt sein.

Bevorzugt lässt sich die asphärische Fläche als Rotationsasphäre einer achsensymmetrischen Kurve darstellen. Die Achse ist dabei beispielsweise durch die optische Achse der Linse gegeben. Die Kurve ist z. B. durch die Meridionalkurve, das heißt, den Schnitt der asphärischen Fläche, mit der Meridionalebene gegeben. Bevorzugt lässt sich die Rotationsasphäre in der folgenden Form darstellen:

$$y = \frac{x^2}{R\left(1 + \sqrt{1 - \frac{(1+c)x^2}{R^2}}\right)} + a_2 x^2 + a_4 x^4 + a_6 x^6 + \ldots$$

Dabei ist y die achsensymmetrische Kurve, c der Asphärenfaktor, R ist der Krümmungsradius und $a_2$, $a_4$, $a_6$ sind Koeffizienten höherer Ordnung. Bevorzugt sind die Koeffizienten höherer Ordnung zumindest teilweise ungleich Null gewählt. Auf diese Weise kann ein besonders flacher, asphärisch gewölbter Bereich erreicht sein, und die Linse zeichnet sich durch eine relativ geringe sphärische Aberration aus.

Bei der Linse handelt es sich also um eine plankonvexe, asphärische Linse. Das heißt, die Linse weist, wie oben beschrieben, wenigstens eine plane und wenigstens eine Fläche auf, die einen konvex gewölbten, asphärischen Bereich enthält. Bevorzugt sind diese beiden Flächen der Linse einander gegenüberliegend angeordnet. Die plane Fläche bildet die Strahlungseintrittsfläche und der konvex, asphärisch gekrümmte Bereich die Strahlungsaustrittsfläche der Linse.

Die Linse enthält ein Material mit einem Brechungsindex größer gleich 3,0. Bevorzugt enthält die Linse ein Material mit einem Brechungsindex zwischen 3,05 und 3,20. Besonders bevorzugt weist das Material diesen Brechungsindex für elektromagnetische Strahlung zumindest in einem Wellenlängenbereich zwischen 800 und 950 nm auf. Bevorzugt weist das Material einen konstanten Brechungsindex auf, das heißt der Brechungsindex ist bevorzugt keine Funktion des Ortes.

Die Linse ist eine plankonvexe Linse, bei der die Höhe des konvex gekrümmten Bereichs maximal 1/5 der Dicke der Linse beträgt. Die Dicke der Linse ist durch den Abstand vom Scheitelpunkt des konvex gewölbten Bereichs der Linse zur gegenüberliegenden planen Fläche gegeben. Bevorzugt verbinden dabei eben ausgestaltete Flächen der Linse die plane Fläche mit der Fläche der Linse, die den konvex gewölbten Bereich aufweist.

Die Höhe des konvex gewölbten Bereichs wird dabei am Scheitelpunkt des konvex gewölbten Bereichs gemessen. Besonders bevorzugt liegt dieser Scheitelpunkt des konvex gewölbten Bereichs auf der optischen Achse der Linse. Die Höhe des konvex gewölbten Bereichs ist der Abstand des Scheitelpunkts des gewölbten Bereichs zur Schnittebene von konvex gekrümmten Bereich und dem restlichen Linsenkörper.

Gemäß zumindest einer Ausführungsform beträgt die Höhe des konvex gekrümmten Bereichs maximal 1/8 der Dicke der Linse.

Die Höhe des konvex gekrümmten Bereichs beträgt maximal 60 μm. Die Höhe des konvex gekrümmten Bereichs der Linse beträgt zwischen 35 und 60 μm.

Gemäß zumindest einer Ausführungsform beträgt die Dicke der Linse, d. h. beispielsweise der Abstand zwischen der planen Strahlungseintrittsfläche der Linse und dem Scheitelpunkt des konvex gekrümmten Bereichs maximal 500 μm. Bevorzugt beträgt die Dicke der Linse zwischen 350 und 500 μm. Besonders bevorzugt beträgt die Dicke der Linse zwischen 425 und 475 μm.

In wenigstens einer Ausführungsform enthält die Linse ein Halbleitermaterial. Das Halbleitermaterial weist einen Brechungsindex von wenigstens 3,0 auf. Besonders bevorzugt weist das Halbleitermaterial diesen Brechungsindex für elektromagnetische Strahlung in einem Wellenlängenbereich zwischen 800 und 950 nm auf. Beispielsweise ist es möglich, dass der Linsenkörper vollständig aus dem Halbleitermaterial besteht. Zumindest ein Teil der Linsenoberfläche kann dann beispielsweise mit einem anderen Material beschichtet sein.

Gemäß zumindest einer Ausführungsform enthält die Linse GaP oder ein anderes auf GaP basierendes Halbleitermaterial, beispielsweise InGaP oder InGaAlP. Beispielsweise ist es möglich, dass der Linsenkörper vollständig aus GaP oder einem GaP-basierten Halbleitermaterial besteht.

Gemäß zumindest einer Ausführungsform beträgt der Betrag des Krümmungsradius R des konvex gekrümmten Bereichs der Linse wenigstens 400 μm, bevorzugt wenigstens 450 μm. Besonders bevorzugt beträgt der Krümmungsradius des konvex gekrümmten Bereichs der Linse zwischen 400 und 500 μm.

Gemäß zumindest einer Ausführungsform beträgt die numerische Apertur der Linse wenigstens 0,7. Bevorzugt beträgt die numerische Apertur der Linse wenigstens 0,8, besonders bevorzugt wenigstens 0,85. Die numerische Apertur der Linse wird bevorzugt möglichst groß gewählt. Besonders bevorzugt ist die numerische Apertur der Linse größer gleich der numerischen Apertur der Strahlungsquelle, mit der elektromagnetische Strahlung in die Linse eingestrahlt wird.

Gemäß wenigstens einer Ausführungsform weist die Strahlungseintrittsfläche oder die Strahlungsaustrittsfläche der Linse eine Anti-Reflexionsbeschichtung auf. Bevorzugt weisen sowohl Strahlungseintrittsfläche als auch Strahlungsaustrittsfläche eine Anti-Reflexionsbeschichtung auf.

Beispielsweise handelt es sich bei der Anti-Reflexionsbeschichtung um eine Beschichtung mit einer Schicht. Die Dicke der Schicht kann beispielsweise an die Wellenlänge angepasst sein, mit der eine vorgebbare Strahlungsquelle Strahlung erzeugt, die durch die Linse tritt. Bevorzugt kann die Schicht $SiN_xO_y$ enthalten.

Weiter ist es möglich, dass die Anti-Reflexionsbeschichtung mehrere Schichten umfasst, die übereinanderliegend angeordnet sind. Beispielsweise kann eine erste der Schichten TaO und eine zweite der Schichten AIO enthalten oder jeweils aus diesen Materialien bestehen.

Die Laseranordnung weist einen Halbleiterchip auf, der zur Erzeugung elektromagnetischer Strahlung geeignet ist. Bevorzugt ist dem Halbleiterchip in Abstrahlrichtung die Linse nachgeordnet, die geeignet ist, die Divergenz der vom Halbleiterchip emittierten Strahlung zu reduzieren.

Dabei ist die Linse dem Halbleiterchip derart nachgeordnet, dass zumindest ein Teil der im Betrieb des Halbleiterchips erzeugten elektromagnetischen Strahlung, die den Halbleiterchip durch eine Strahlungsauskoppelfläche des Halbleiterchips verlässt, durch eine plane Strahlungseintrittsfläche der Linse eintritt. Die Strahlung verlässt die Linse durch einen konvex gewölbten Bereich auf der der Strahlungseinkoppelfläche gegenüberliegenden Fläche der Linse. Nach dem Durchtritt durch die Linse weist die elektromagnetische Strahlung bevorzugt eine geringere Divergenz als vor Eintritt in die Linse auf. ,

Der Abstand zwischen Strahlungsauskoppelfläche des Halbleiterchips und der Strahlungseintrittsfläche der Linse beträgt maximal 80 μm. Bevorzugt beträgt der Abstand maximal 75 μm, besonders bevorzugt maximal 50 μm.

Gemäß zumindest einer Ausführungsform der Laseranordnung handelt es sich bei dem Halbleiterchip um eines der folgenden Bauteile: Leuchtdiodenchip, Laserbarren, Halbleiterlaserchip. Bevorzugt ist der Halbleiterchip zur Erzeugung von Laserstrahlung in einem Wellenlängenbereich von 800 bis 950 nm geeignet. Besonders bevorzugt kann der Halbleiterchip Laserstrahlung im Dauerbetrieb (cw-Betrieb) erzeugen. Die Leistungsaufnahme des Halbleiterchips beträgt bevorzugt wenigstens 20 W.

Halbleiterchip und Linse sind auf einem gemeinsamen Träger aufgebracht. Halbleiterchip und Linse sind auf einem Leiterrahmen aufgebracht.

Die Linse ist auf dem Träger mittels eines Klebstoffs befestigt. Dabei kann es sich beispielsweise um einen temperaturbeständigen Klebstoff handeln. Der Klebstoff ist zwischen dem Leiterrahmen und einer ebenen Fläche der Linse angeordnet, die senkrecht zur planen Strahlungseintrittsfläche der Linse verläuft.

Der Halbleiterchip ist mittels einer Hartlotverbindung auf dem Leiterrahmen befestigt, d. h. der Halbleiterchip ist mittels eines Hartlotes auf den Leiterrahmen gelötet. Es ist aber auch möglich, dass der Halbleiterchip auf ein Wärmeleitelement mittels eines Hartlotes gelötet ist und das Wärmeleitelement ebenfalls mittels einer, Hartlotverbindung auf den Leiterrahmen gelötet ist.

Beispielsweise kann das Hartlot AuSn enthalten. Bevorzugt weist das Hartlot einen Schmelzpunkt von 280°C oder höher auf.

Es wird weiter ein Verfahren zur Herstellung einer Laseranordnung angegeben. Mittels des Verfahrens wird eine Laseranordnung gemäß einer der oben beschrieben Ausführungsformen hergestellt.

Bei dem Verfahren wird die Linse mittels einer Saugpinzette in den Strahlengang des Halbleiterchips gesetzt. Beispielsweise weist die Linse eine Dicke von maximal 600 μm auf.

Die Linse weist wenigstens zwei einander gegenüberliegende plane Flächen auf, die parallel zur optischen Achse der Linse verlaufen und senkrecht auf einer planen Strahlungseintrittsfläche der Linse stehen. Die beiden planen Flächen verbinden die Strahlungseintrittsfläche der Linse mit einer Fläche der Linse, die einen konvex gewölbten Strahlungsaustrittsbereich der Linse umfasst.

Die Länge der beiden planen Flächen in Richtung der optischen Achse beträgt wenigstens 350 μm, besonders bevorzugt wenigstens 390 μm.

Bevorzugt greift die Saugpinzette bei der Montage der Linse an einer der beiden planen Flächen an und setzt die Linse mit der gegenüberliegenden planen Fläche auf einem Träger ab. Dabei wird zur Befestigung der Linse zwischen Träger und Linse ein Klebstoff angeordnet.

Im Folgenden wird die hier beschriebene Laseranordnung anhand von Ausführungsbeispielen und den dazugehörigen Figuren näher erläutert.

In den Ausführungsbeispielen und Figuren sind gleiche oder gleich wirkende Bestandteile jeweils mit den gleichen Bezugzeichen versehen. Die dargestellten Elemente sind nicht als maßstabsgerecht anzusehen, vielmehr können einzelne Elemente zum besseren Verständnis übertrieben, groß dargestellt sein.

Figur 1 zeigt eine schematische Schnittdarstellung eines Ausführungsbeispiels einer Linse für eine hier beschriebene Laseranordnung.

Figur 2 zeigt eine schematische Schnittdarstellung eines ersten Ausführungsbeispiels der hier beschriebenen Laseranordnung.

Figur 3 zeigt eine schematische Schnittdarstellung eines weiteren Ausführungsbeispiels der hier beschriebenen Laseranordnung.

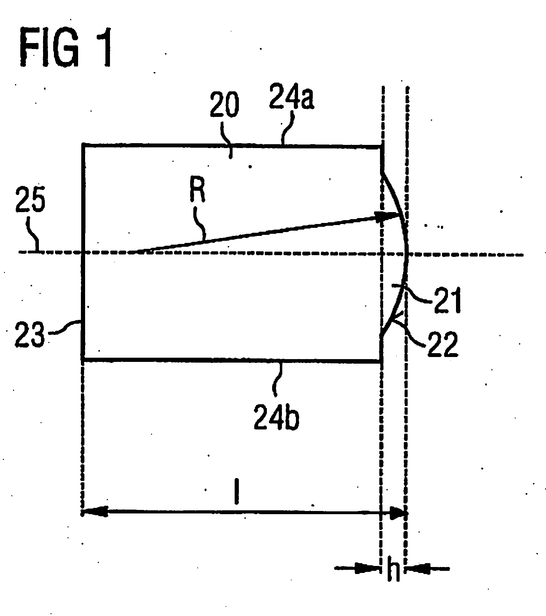

Die Linse 20 weist beispielsweise eine Strahlungseintrittsfläche 23 auf. Der Strahlungseintrittsfläche 23 gegenüberliegend ist ein konvex gewölbter Bereich 21 angeordnet, der eine Höhe h aufweist. Der konvex gewölbte Bereich kann sich über die gesamte der Strahlungseintrittsfläche 23 gegenüberliegenden Fläche der Linse erstrecken. Es ist aber auch möglich, dass der konvex gewölbte Bereich, wie in Figur 1 dargestellt, lediglich einen Teil dieser Fläche einnimmt.

Der konvex gewölbte Bereich 21 ist von der asphärischen Fläche 22 abgeschlossen, die die Strahlungsaustrittsfläche der Linse bildet. Der Abstand zwischen Strahlungseintrittsfläche 23 und dem Scheitelpunkt der asphärisch, konvex gewölbten Fläche 22 wird als Dicke 1 der Linse bezeichnet. Zum Beispiel ist der Scheitelpunk der gewölbten Fläche dabei auf der optischen Achse 25 der Linse angeordnet.

Strahlungseintrittsfläche 23 und die Fläche der Linse 20, die den konvex gewölbten Bereich 21 umfasst, sind durch ebene Seitenflächen 24a und 24b miteinander verbunden. Eine dieser Seitenflächen, beispielsweise die Seitenfläche 24b, dient als Montagefläche der Linse, mit der die Linse beispielsweise auf einem Träger befestigt werden kann. Die gegenüberliegende Seitenfläche 24a kann bei der Montage der Linse 20 beispielsweise als Ansaugfläche für eine Saugpinzette dienen.

Die Linse 20 enthält beispielsweise GaP oder ein auf GaP basierendes Halbleitermaterial wie beispielsweise InGaP oder InGaAlP. Die Linse kann entweder eines dieser Materialien enthalten oder aus einem dieser Materialien bestehen. Beispielsweise GaP weist für elektromagnetische Strahlung im Wellenlängenbereich von ca. 800 bis 950 nm einen Brechungsindex von ca. 3,10 bis 3,14 auf.

Beispielsweise auf die Strahlungseintrittsfläche 23 und die asphärische Fläche 22 kann eine Anti-Reflexionsbeschichtung aufgebracht sein (nicht dargestellt). Die Anti-Reflexionsbeschichtung kann z. B. der Wellenlänge der elektromagnetischen Strahlung, für die die Linse vorgesehen ist, angepasst sein. Beispielsweise ist die Anti-Reflexionsbeschichtung als einzelne Schicht ausgeführt, die z. B. $SIN_xO_y$ enthalten kann. Es ist auch möglich, dass die Anti-Reflexionsbeschichtung als Abfolge von mehreren Schichten ausgebildet ist. Beispielsweise kann die Anti-Reflexionsbeschichtung eine Schicht umfassen, die TaO enthält, und eine weitere Schicht, die AlO enthält. Bevorzugt wird die Anti-Reflexionsbeschichtung noch im Waferverbund auf die Oberfläche der Linsen beispielsweise aufgedampft.

Die Herstellung der Linse 20 kann beispielsweise mittels Ätzen der Linsenstruktur im Waferverbund und anschließendes Vereinzeln, beispielsweise mittels Sägen, erfolgen.

Zur Erzeugung der asphärischen Fläche 22 wird beispielsweise zunächst eine Fotolackschicht auf einem Linsensubstrat erzeugt. Nachfolgend wird die Fotolackschicht zu einer Lacklinse strukturiert. Die Struktur der Fotolacklinse kann dann mittels eines anisotropen Ätzverfahrens, wie beispielsweise reaktives Ionenätzen, zumindest teilweise auf das darunterliegende Linsensubstrat übertragen werden.

Außerdem eignen sich auch Ätzverfahren wie anodisch gekoppeltes Plasmaätzen im Parallelplattenreaktor, triodenreaktives Ionenätzen, induktiv gekoppeltes Plasmaätzen oder ähnliche Verfahren. Bevorzugt kommen beim verwendeten Herstellungsverfahren mehrere Gaskomponenten mit unterschiedlicher Selektivität gegenüber der Fotolackschicht und dem Linsensubstrat zum Einsatz. Die Selektivität bezeichnet dabei das Verhältnis der Ätzrate des Linsensubstrats und der Ätzrate des Fotolacks. Bei einer Selektivität von 1 etwa wird die Form der Lacklinse im Wesentlichen unverändert auf das Linsensubstrat übertragen. Eine Selektivität von > 1 führt dagegen zu einer Überhöhung der geätzten Halbleiterlinse verglichen mit der Fotolacklinse. Die Selektivität des Ätzverfahrens bestimmt also zusammen mit der Ausgangsform der Lacklinse die Form der erzeugten Linse 20.

Die Form der asphärischen Fläche 22 der Linse 20 ist dabei, wie weiter oben beschrieben, durch die Rotationsasphäre in einer achsensymmetrischen Kurve y beschrieben mit

$$y = \frac{x^2}{R\left(1 + \sqrt{1 - \frac{(1+c)x^2}{R^2}}\right)} + a_2 x^2 + a_4 x^4 + a_6 x^6 + \dots$$

Je nach Wahl der Linsenparameter wie Krümmungsradius R, Asphärenfaktor c, Koeffizienten höherer Ordnung sowie der Linsendicke 1 und der Höhe h des konvex gekrümmten Bereichs 21 ist es möglich, eine plankonvexe asphärische Linse 20 mit gewünschter Kollimation und gewünschter numerischer Apertur herzustellen.

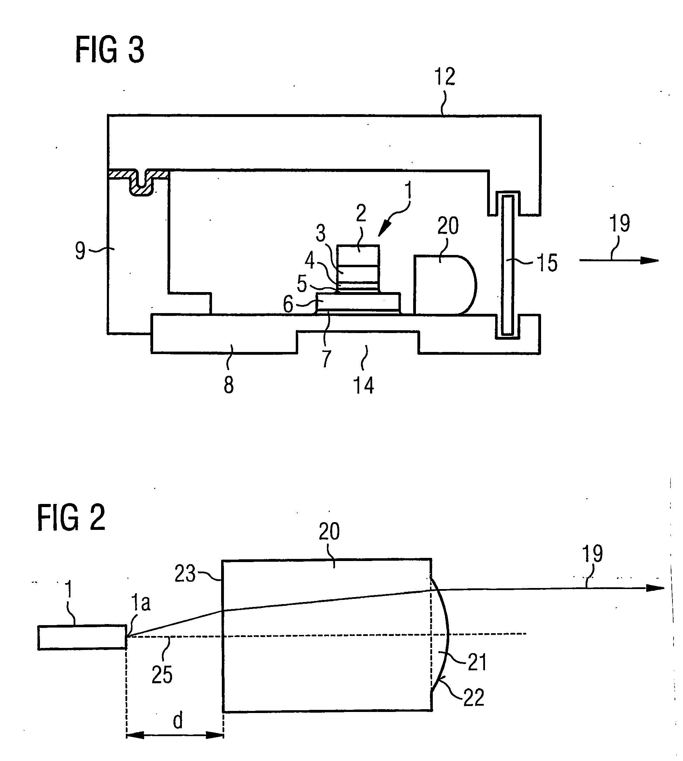

Die Eigenschaften der Linse 20 sind beispielsweise den Einsatzerfordernissen an die Linse 20 in einer Laseranordnung, wie sie in Figur 2 in einem ersten Ausführungsbeispiel dargestellt ist, angepasst. Die Strahlungsauskoppelfläche 1a des strahlungserzeugenden Halbleiterchips 1 befindet sich dabei in einem Arbeitsabstand d von der Strahlungseintrittsfläche 23 der Linse 20. Die Linse 20 ist geeignet, die Divergenz der vom Halbleiterchip erzeugten elektromagnetischen Strahlung zu verringern. Dazu wird die elektromagnetische Strahlung 19 bereits bei ihrem Eintritt an der Strahlungseintrittsfläche 23 zur optischen Achse 25 der Linse 20 hin gebrochen. Bei Strahlungsaustritt durch die asphärische Fläche 22 findet eine weitere Brechung zur optischen Achse hin statt. Die numerische Apertur des Halbleiterchips beträgt dabei beispielsweise zwischen 0,75 und 0,85, bevorzugt 0,8.

Gemäß eines Ausführungsbeispiels der Laseranordnung wird bei einer Linsendicke von ca. 450 $\mu$m ein Arbeitsabstand von 75 $\mu$m zwischen Halbleiterchip und Linse gewählt. Eine numerische Apertur von ca. 0.82 kann,beispielsweise durch eine Wahl des Krümmungsradius von R = -454 $\mu$m und einen Asphärenfaktor von c = -2,539 erreicht sein. Die Höhe h des gewölbten Bereichs der Linse 20 beträgt dabei 50 $\mu$m. Weitere höhere Ordnungen der Linsenparameter sind dabei gleich Null.

Es können aber auch höhere Ordnungen der Linsenparameter berücksichtigt werden. Bei gleichem Arbeitsabstand von d = 75 $\mu$m und einer unveränderten Linsendicke 1 von 450 $\mu$m wird mit dem Parametersatz R = -465 $\mu$m, c = -1.772, $a_2$ = 0, $a_4$ = 0,025 und $a_6$ = 10,106 eine numerische Apertur von 0,82 bei einer Höhe h des gewölbten Bereichs 21 von 49 $\mu$m erreicht. Bei diesem Ausführungsbeispiel ist die Linse also etwas flacher. Nach außen hin, d. h. von der optischen Achse weg gerichtet, ist die Linse geradliniger als im ersten Ausführungsbeispiel. Die Linse zeichnet sich zudem durch eine geringere sphärische Aberration aus.

In einem weiteren Ausführungsbeispiel der Laseranordnung wird bei einer Linsendicke von 450 $\mu$m ein Arbeitsabstand von d = 50 $\mu$m eingestellt. Bei einer Wahl von R = -403 $\mu$m und c = - 2,084 kann dabei eine numerische Apertur von 0.89 erreicht werden, wobei die Höhe h des konvex gekrümmten Bereichs 21 56 $\mu$m beträgt.

Unter Hinzunahme höherer Ordnungen kann bei gleicher Linsendicke 1 = 450 $\mu$m sowie gleichem Arbeitsabstand d = 50 $\mu$m eine Höhe h von 55 $\mu$m bei einer numerischen Apertur von 0,89 erreicht werden, wobei R = -413 $\mu$m, c = -1,372, $a_2$ = 0, $a_4$ = -0.025 und $a_6$ = 25,803 gewählt werden. Die Linse zeichnet sich dann zudem durch eine geringere sphärische Aberration aus.

Die Herstellungsbedingten Fehler betragen dabei bei allen, Ausführungsbeispielen für die Linsendicke maximal 2%, für'die Linsenform (R, c, weitere Formparameter) maximal zwischen 5% und 10%.

Figur 3 zeigt ein weiteres Ausführungsbeispiel der Laseranordnung.

Die Laseranordnung weist einen Halbleiterchip 1 auf, bei dem es sich beispielsweise um einen Laserdiodenchip oder einen Laserbarren handeln kann. Der Halbleiterchip enthält bevorzugt mindestens ein III-V Halbleitermaterial, umfassend InGayAl$_{1-x-y}$P, In$_x$Ga$_y$Al$_{1-x-y}$N oder In$_x$Ga$_y$Al$_{1-x-y}$As mit jeweils $0 \le x \le 1$, $0 \le y \le 1$ und x + y $\le$ 1. Beispielsweise ist der Halbleiterchip 1 geeignet, Laserstrahlung im Dauerbetrieb zu erzeugen. Die Wellenlänge der erzeugten Laserstrahlung kann beispielsweise zwischen 800 und 950 nm liegen. Beispielsweise weist der Halbleiterchip bei der Strahlungserzeugung eine Leistungsaufnahme von wenigstens 20 W auf.

Der Halbleiterchip 1 umfasst eine auf einem Substrat 2 angeordnete Halbleiterschichtenfolge 3 mit wenigstens einer strahlungserzeugenden aktiven Zone 4. Dazu kann die aktive Zone 4 beispielsweise einen pn-Übergang, eine Doppelheterostruktur, eine Einfach-Quantentopf- oder besonders bevorzugt eine Mehrfach-Quantentopfstruktur (MQW) aufweisen.

Die Bezeichnung Quantentopfstruktur umfasst im Rahmen der Anmeldung insbesondere auch jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Der Halbleiterchip 1 ist im Ausführungsbeispiel der Laseranordnung der Figur 3 auf einem Wärmeleitelement 6 befestigt, das beispielsweise CuW enthalten kann. Beispielsweise ist der Halbleiterchip mittels einer Upside-Down-Montagetechnik auf dem Wärmeleitelement befestigt. Das Wärmeleitelement 6 leitet die beim Betrieb im Halbleiterchip 1 erzeugte Wärme an den Leiterrahmen 8 ab. Vorzugsweise ist der thermische Ausdehnungskoeffizient des Wärmeleitelements 6 dabei an den thermischen Ausdehnungskoeffizienten des Halbleiterchips 1 angepaßt.

Der Halbleiterchip 1 ist mittels eines Lots 5 auf dem Wärmeleitelement 6 befestigt. Das Wärmeleitelement 6 ist seinerseits mittels eines Lots 7 auf dem Leiterrahmen 8 befestigt. Es handelt sich bei den Loten 5, 7 um Hartlote, wie beispielsweise AuSn. Der Leiterrahmen 8 kann beispielsweise ein thermisch leitendes Material wie beispielsweise Cu enthalten. Zusätzlich kann an der Unterseite des Leiterrahmens 8, d. h. auf der Seite, die dem Halbleiterchip 1 abgewandt ist, eine weitere Kühlstruktur 14, enthaltend beispielsweise Kühlrippen oder ein Kühlkanal, angeordnet sein.

An den Leiterrahmen 8 ist ein Gehäuseteil 9 angeformt, das einen Kunststoff wie PEEK oder temperaturbeständiges LCP (Liquid Crystal Polymer) enthält. Bevorzugt erfolgt das Anformen des Gehäuseteils 9 vor der Befestigung des Halbleiterchips auf dem Leiterrahmen 8. Das Gehäuseteil 9 umgibt den Leiterrahmen 8 bevorzugt zumindest teilweise. Beispielsweise kann das Gehäuseteil 9 mittels Spritzguss-, Spritzpress- oder mittels eines Pressgussverfahrens hergestellt sein.

Auf das Gehäuseteil 9 kann ein Gehäusedeckel 12 aufgebracht sein. Bevorzugt enthält der Gehäusedeckel 12 das gleiche Material wie das Gehäuseteil 9 und wird nach der Montage des Halbleiterchips 1 und der Linse 20 auf dem Leiterrahmen 8 befestigt.

Die Linse 20 ist auf den Leiterrahmen 8 geklebt, wobei der Klebstoff zwischen der planen Fläche 24b und dem Leiterrahmen 8 angeordnet ist. Beispielsweise wird die Linse 20 mittels einer Saugpinzette, die an der planen Fläche 24a angreift, auf den Leiterrahmen 8 gesetzt, positioniert, das heißt, relativ zum Halbleiterchip 1 justiert, und befestigt. Zur Befestigung kann ein temperaturbeständiger, UV-härtbarer Klebstoff zum Einsatz kommen. Die vom Halbleiterchip 1 erzeugte elektromagnetische Strahlung 19 tritt zunächst durch die Linse 20 und von dort durch eine zumindest teilweise strahlungsdurchlässige Fensterschicht 15 aus der Laseranordnung aus.

Bevorzugte äußere Abmessungen für die Laseranordnung sind dabei für die Höhe zwischen 2mm und 4mm, bevorzugt 3mm, für die Breite zwischen 8mm und 12mm, bevorzugt 10mm und für die Tiefe zwischen 8mm und 12mm, bevorzugt 10mm. Weiter weist die Laseranordnung bevorzugt 10x10 Pins zum elektrischen Anschließen auf.

**Patentansprüche**

1. Laseranordnung, aufweisend

   - einen zur Erzeugung von elektromagnetischer Strahlung (19) geeigneten Halbleiterchip (1), und
   - eine asphärische plankonvexe Linse (20), die ein Material mit einem Brechungsindex von wenigstens 3,0 enthält, bei der die Höhe (h) des konvex gekrümmten Bereichs (21) maximal ein Fünftel der Dicke (1) der Linse (20) beträgt, wobei
   - die Dicke (1) der Linse (20) der Abstand zwischen einem Scheitelpunkt des konvex gewölbten Bereichs (21) und der dem konvex gewölbten Bereich (21) gegenüberliegenden planen Strahlungseintrittsfläche (23) ist,
   - die Linse (20) dem Halbleiterchip (1) in Abstrahlrichtung nachgeordnet ist,
   - die Linse (20) mit ihrer planen Strahlungseintrittsfläche (23) dem Halbleiterchip (1) zugewandt ist,
   - Halbeiterchip (1) und Linse (20) auf einem gemeinsamen Träger (8) aufgebracht sind,
   - die Linse (20) zwei einander gegenüberliegende plane Flächen (24a, 24b) aufweist, die parallel zur optischen Achse (25) der Linse (20) verlaufen und senkrecht auf der planen Strahlungseintrittsfläche (23) stehen,
   - die Länge der beiden planen Flächen (24a, 24b) in Richtung der optischen Achse (25) wenigstens 350 μm beträgt,

   **dadurch gekennzeichnet, dass**

   - die Strahlungsauskoppelfläche (1a) des Halbleiterchips (1) in einem Abstand (d) zur Strahlungseintrittsfläche (23) der Linse (20) angeordnet ist, der maximal 80 μm beträgt,
   - die Höhe des konvex gekrümmten Bereichs zwischen 35 μm und 60 μm beträgt,
   - der gemeinsame Träger (8) ein Leiterrahmen ist,
   - die Linse auf dem Leiterrahmen mittels eines Klebstoffs befestigt ist, wobei der Klebstoff zwischen dem Leiterrahmen und der dem Leiterrahmen zugewandten planen Fläche (24b) der Linse angeordnet ist, und
   - der Halbleiterchip mittels einer Hartlotverbindung auf dem Leiterrahmen befestigt ist.

2. Laseranordnung nach Anspruch 1,
   bei der die Höhe (h) des konvex gekrümmten Bereichs (21) maximal ein Achtel der Dicke (1) der Linse beträgt.

3. Laseranordnung nach einem der Ansprüche 1 oder 2,
   bei der die Dicke (1) der Linse (20) zwischen 350 und 500 μm beträgt.

4. Laseranordnung nach einem der Ansprüche 1 bis 3,
   bei der das Material der Linse (20) ein Halbleitermaterial umfasst.

5. Laseranordnung nach Anspruch 4,
   bei der das Material GaP umfasst.

6. Laseranordnung nach einem der Ansprüche 1 bis 5,
   bei der der Betrag des Krümmungsradius (R) des konvex gekrümmten Bereichs (21) der Linse (20) wenigstens 400 μm beträgt.

**7.** Laseranordnung nach einem der Ansprüche 1 bis 6,
bei der die numerische Apertur der Linse (20) wenigstens 0,7 beträgt.

**8.** Laseranordnung nach einem der Ansprüche 1 bis 7,
bei der zumindest die Strahlungseintrittsfläche (23) und die Strahlungsaustritttsfläche (22) der Linse (20) eine Anti-Reflexionsbeschichtung aufweisen.

**9.** Laseranordnung nach Anspruch 8,
bei der die Anti-Reflexionsbeschichtung wenigstens eines der folgenden Materialien enthält: SiNO, TaO, AlO.

**10.** Laseranordnung nach einem der vorherigen Ansprüche,
bei der der Halbleiterchip (1) eines der folgenden Bauteile ist: Laserdiodenchip, Laserdiodenbarren.

**11.** Laseranordnung nach einem der vorherigen Ansprüche,
bei der der Halbleiterchip (1) geeignet ist, elektromagnetische Strahlung (19) in einem Wellenlängenbereich zwischen 800 und 950 nm zu erzeugen.

**12.** Verfahren zur Herstellung einer Laseranordnung nach einem der vorherigen Ansprüche,
wobei die Linse (20) unter Verwendung einer Saugpinzette in den Strahlengang des Halbleiterchips (1) gesetzt wird.

**13.** Verfahren nach Anspruch 12,
wobei die Dicke (1) der Linse (20) maximal 600$\mu$m beträgt.

**14.** Verfahren nach Anspruch 13,
wobei die Saugpinzette an einer planen Fläche (24a) der Linse (20) angreift und die Linse (20) mit einer gegenüberliegenden planen Fläche (24b) auf einen Träger gesetzt wird.

**Claims**

**1.** Laser assembly, comprising

- a semiconductor chip (1) suitable for generating electromagnetic radiation (19), and
- an aspherical planoconvex lens (20) containing a material having a refractive index of at least 3.0 in the case of which lens the height (h) of the convexly curved region (21) is at most one fifth of the thickness (1) of the lens (20), wherein
- the thickness (1) of the lens (20) is the distance between a vertex of the convexly curved region (21) and the planar radiation entrance surface (23) lying opposite the convexly curved region (21),
- the lens (20) is disposed downstream of the semiconductor chip (1) in the emission direction,
- the lens (20) faces the semiconductor chip (1) with its planar radiation entrance surface (23),
- semiconductor chip (1) and lens (20) are applied on a common carrier (8),
- the lens (20) comprises two planar surfaces (24a, 24b) which lie opposite one another and which run parallel to the optical axis (25) of the lens (20) and are perpendicular to the planar radiation entrance surface (23),
- the length of the two planar surfaces (24a, 24b) in the direction of the optical axis (25) is at least 350 $\mu$m,

**characterized in that**
the radiation coupling-out surface (1a) of the semiconductor chip (1) is arranged at a distance (d) from the radiation entrance surface (23) of the lens (20) which is at most 80 $\mu$m,

- the height of the convexly curved region is between 35 $\mu$m and 60 $\mu$m,
- the common carrier (8) is a leadframe,
- the lens is fixed on the leadframe by means of an adhesive, wherein the adhesive is arranged between the leadframe and that planar surface (24b) of the lens which faces the leadframe, and
- the semiconductor chip is fixed on the leadframe by means of a hard solder connection.

**2.** Laser assembly according to claim 1,
wherein the height (h) of the convexly curved region (21) is at most one eighth of the thickness (1) of the lens.

3. Laser assembly according to either of claims 1 and 2,
   wherein the thickness (1) of the lens (20) is between 350 and 500 µm.

4. Laser assembly according to any of claims 1 to 3,
   wherein the material of the lens (20) comprises a semiconductor material.

5. Laser assembly according to claim 4,
   wherein the material comprises GaP.

6. Laser assembly according to any of claims 1 to 5,
   wherein the magnitude of the radius (R) of curvature of the convexly curved region (21) of the lens (20) is at least 400 µm.

7. Laser assembly according to any of claims 1 to 6,
   wherein the numerical aperture of the lens (20) is at least 0.7.

8. Laser assembly according to any of claims 1 to 7,
   wherein at least the radiation entrance surface (23) and the radiation exit surface (22) of the lens (20) comprise an antireflection coating.

9. Laser assembly according to claim 8,
   wherein the antireflection coating contains at least one of the following materials: SiNO, TaO, AlO.

10. Laser assembly according to any of the preceding claims,
    wherein the semiconductor chip (1) is one of the following components: laser diode chip, laser diode bar.

11. Laser assembly according to any of the preceding claims,
    wherein the semiconductor chip (1) is suitable for generating electromagnetic radiation (19) in a wavelength range of between 800 and 950 nm.

12. Method for producing a laser assembly according to any of the preceding claims,
    wherein the lens (20) is placed into the beam path of the semiconductor chip (1) using suction forceps.

13. Method according to claim 12,
    wherein the thickness (1) of the lens (20) is at most 600 µm.

14. Method according to claim 13,
    wherein the suction forceps act on one planar surface (24a) of the lens (20) and the lens (20) is placed onto a carrier by an opposite planar surface (24b).

**Revendications**

1. Système laser présentant

   - une puce semi-conductrice (1) permettant de produire un rayonnement électromagnétique (19) et
   - une lentille plan convexe asphérique (20) qui contient un matériau dont l'indice de réfraction est d'au moins 3,0, la hauteur (h) de la partie (21) de courbure convexe représentant au plus un cinquième de l'épaisseur (1) de la lentille (20),
   - l'épaisseur (1) de la lentille (20) étant la distance entre le sommet de la partie (21) de courbure convexe et la surface plane (23) d'entrée de rayonnement située face à la partie (21) de courbure convexe,
   - la lentille (20) étant disposée en aval de la puce semi-conductrice (1) dans la direction d'émission,
   - la lentille (20) étant tournée vers la puce semi-conductrice (1) avec la surface plane (23) d'entrée de rayonnement,
   - la puce semi-conductrice (1) et la lentille (20) étant placées sur un support commun (8),
   - la lentille (20) présentant deux surfaces planes (24a, 24b) situées l'une en face de l'autre, qui s'étendent parallèlement à l'axe optique (25) de la lentille (20) et perpendiculairement à la surface plane (23) d'entrée de rayonnement,

- la longueur des deux surfaces planes (24a, 24b) dans la direction de l'axe optique (25) étant d'au moins 350 μm,

**caractérisé en ce que**

- la surface (1a) de sortie de rayonnement de la puce semi-conductrice (1) est disposée à une distance (d) de la surface (23) d'entrée de rayonnement de la lentille (20) qui est d'au plus 80 μm,
- **en ce que** la hauteur de la partie de courbure convexe est comprise entre 35 μm et 60 μm,
- **en ce que** le support commun (8) est un encadrement conducteur,
- **en ce que** la lentille est fixée sur l'encadrement conducteur au moyen d'un adhésif, l'adhésif étant disposé entre l'encadrement conducteur et la surface plane (24b), tournée vers l'encadrement conducteur, de la lentille et
- **en ce que** la puce semi-conductrice est fixée sur l'encadrement conducteur au moyen d'une liaison par brasure.

2. Système laser selon la revendication 1, dans lequel la hauteur (h) de la partie (21) de courbure convexe représente au maximum un huitième de l'épaisseur (1) de la lentille.

3. Système laser selon l'une des revendications 1 ou 2, dans lequel l'épaisseur (1) de la lentille (20) est comprise entre 350 et 500 μm.

4. Système laser selon l'une des revendications 1 à 3, dans lequel le matériau de la lentille (20) comprend un matériau semi-conducteur.

5. Système laser selon la revendication 4, dans lequel le matériau contient du GaP.

6. Système laser selon l'une des revendications 1 à 5, dans lequel la valeur du rayon de courbure (R) de la partie (21) de courbure convexe de la lentille (20) est d'au moins 400 μm.

7. Système laser selon l'une des revendications 1 à 6, dans lequel l'ouverture numérique de la lentille (20) est d'au moins 0,7.

8. Système laser selon l'une des revendications 1 à 7, dans lequel au moins la surface (23) d'entrée de rayonnement et la surface (22) de sortie de rayonnement de la lentille (20) présentent un revêtement anti-réfléchissant.

9. Système laser selon la revendication 8, dans lequel le revêtement anti-réfléchissant contient au moins l'un des matériaux suivants : SiNO, TaO, AlO.

10. Système laser selon l'une des revendications précédentes, dans lequel la puce semi-conductrice (1) est l'un des composants suivants : puce de diode laser ou barre de diode laser.

11. Système laser selon l'une des revendications précédentes, dans lequel la puce semi-conductrice (1) est capable de produire un rayonnement électromagnétique (19) dans une partie de longueurs d'onde comprise entre 800 et 950 nm.

12. Méthode de fabrication d'un système laser selon l'une des revendications précédentes, dans laquelle la lentille (20) est placée dans le parcours des rayons de la puce semi-conductrice (1) en utilisant une pincette de succion.

13. Méthode selon la revendication 12, dans laquelle l'épaisseur (1) de la lentille (20) est d'au plus 600 μm.

14. Méthode selon la revendication 13, dans laquelle la pincette de succion engage une surface plane (24a) de la lentille (20) et la lentille (20) est placée sur un support par une surface plane (24b) opposée à la première.

FIG 1

## FIG 3

## FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4830454 A
- DE 10142010 A1
- DE 19527026 A1

- US 5963577 A
- US 5757830 A

**In der Beschreibung aufgeführte Nicht-Patentliteratur**

- Fabrication of refractive microlenses in semiconductors by mask shape transfer in reactive ion etching. **Strzelecka E. M. et al.** Microelectronic Engineering. Elsevier Publishers BV, Februar 1997, vol. 35, 385-388

- **Liau Z. L. et al.** Simple Compact Diode-Laser/Microlens Packaging. *IEEE Journal of Quantum Electronics, IEEE Service Center,* Marz 1997, vol. 33 (3), 457-461